# EUROPEAN PATENT APPLICATION

(11) **EP 4 625 898 A1**
(43) Date of publication of application: **01.10.2025**
(21) Application number: 25152276.9
(22) Date of filing: 16.01.2025
(51) Int. Cl.: H04L 25/06

(54) **SAMPLER CIRCUIT CALIBRATION**

(30) Priority: 28.03.2024 US 202418619686
(71) Applicant: INTEL Corporation, Santa Clara, CA 95054 (US)
(72) Inventor: KULKARNI, Raghavendra, 560061 Bengaluru (IN); KUNA, Ashok Kumar, 532474 Srikakulam (IN); KESHWANI, Ankuj, Bangalore (IN); KUNDA, Rajesh Babu, 516431 JammalaMadugu (IN)
(74) Representative: Viering, Jentschura & Partner mbB Patent- und Rechtsanwälte

(57) **Abstract**

For receiver circuits, Sampler offset calibration techniques are provided. In some embodiments, an output of an analog front end circuit may be tuned to a reference level that is used for an input of the sampler, and the sampler may then be calibrated to reduce an offset between its inputs.

## Description

### TECHNICAL FIELD

Embodiments of the invention relate to the field of integrated circuits; and more specifically, to the field of I/O interconnection links.

### BRIEF DESCRIPTION OF THE DRAWINGS

The disclosure may best be understood by referring to the following description and accompanying drawings that are used to illustrate embodiments of the invention. In the drawings:
Fig. 1 is a diagram showing a portion of a conventional single-ended receiver circuit.
Fig. 2 is a circuit diagram showing a portion of a receiver with offset calibration in accordance with some embodiments.
Fig. 3 is a schematic diagram showing a portion of a receiver circuit having offset calibration in accordance with some embodiments.
Fig. 4 is a flow diagram showing a routine to calibrate a sampler circuit's offset in accordance with some embodiments.
Figs. 5A and 5B are top and side view diagrams showing an exemplary multi-die package having die-to-die interconnect links in accordance with some embodiments.
Figs. 6A and 6B are top and side view diagrams showing an exemplary multi-package apparatus having package-to-package interconnect links in accordance with some embodiments.
Fig. 7 illustrates an example computing system in accordance with some embodiments.
Fig. 8 illustrates a block diagram of an example processor and/or SoC 800 that may have one or more cores and an integrated memory controller in accordance with some embodiments.

### DETAILED DESCRIPTION

The requirement for high-performance computing, e.g., in artificial intelligence and data center computing, has led to a need for high speed and low power die to die (D2D) and package to package (P2P) interconnects. Advanced single-ended links are commonly used or at least being considered for implementing these D2D and P2P links. In order to satisfy these demands, advanced single-ended links such as UCIe (Universal Chiplet Interconnect Express) require ever higher data rates, for example, of more than 16 Gbps over channels with 6-10 dB insertion losses. Being single ended with tight eye margins, they can be prone to excessive noise resulting from cross talk, inter symbol interference (ISI) and other distorting sources. As a result, such links typically require receiver samplers with accurate offset cancellation without which would otherwise be susceptible to vertical and horizontal eye loss. These issues only get worse as the data rates increase, e.g., beyond 16-40 Gbps.

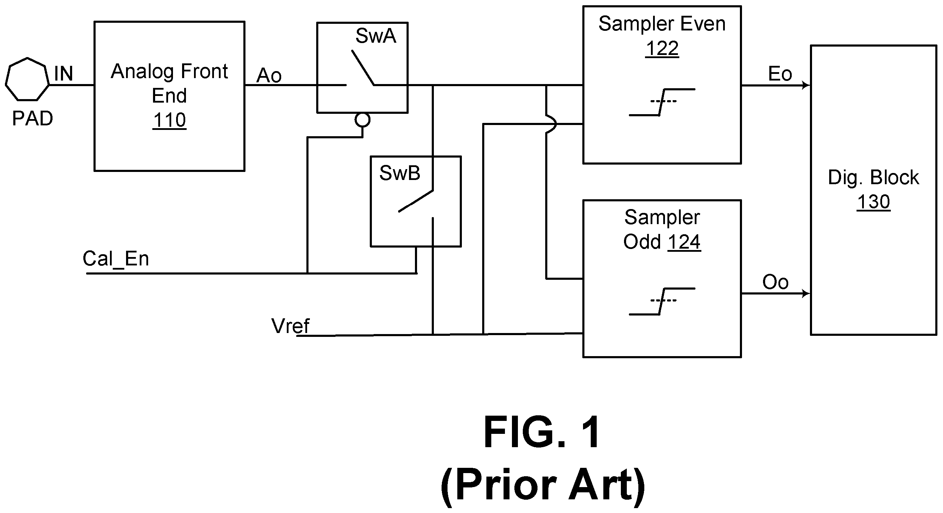

Fig. 1 is a diagram showing a portion of a conventional single-ended receiver circuit. The circuit generally includes an analog front end (AFE) circuit 110, even/odd sampler circuits 122, 124, respectively, and a digital circuit block 130, coupled as shown. The AFE 110 receives a single-ended input data stream signal (IN), amplifies it, and provides the amplified version (Ao) at its output.

The even and odd sampler circuits 122, 124 receive the amplified bit stream (Ao) and digitize the signal based on a reference level (Vref) and forwarded clock (not shown). The even and odd samplers alternate in operation with one of them sampling off of the clock's rising edge, while the other samples off of its falling edge. In this way, a double data rate may be attained with respect to the clock's frequency. The digitized signals (Eo, Oo) are then provided to the digital circuit block 130 where they are de-serialized and combined with other signals from the interconnect interface.

In order to calibrate the samplers and reduce their offsets, switches SwA and SwB are included to isolate the samplers from the AFE 110 and reference voltage (Vref) during a calibration mode. Durin this mode, SwA is opened while SwB is closed, disconnecting the AFE from the samplers and shorting the inputs for each sampler to one another. In this way, the digital circuit block can then tune the sampler by adjusting either or both of its input leg drive strengths to identify where the sampler output changes value. If the drive strength increments are small enough, the cross-over setting corresponds to an internal offset that may be suitably small. Unfortunately, a drawback with this scheme is that it requires a switch in the data path, which can add additional ISI, e.g., up to 3 dB at 8 GHz. That is, the sampler is calibrated with a switch in the offset path between its inputs, but the switch is not part of this path during operational mode. The sampler kickback noise mismatch between calibration mode and operational mode makes this approach inaccurate (e.g., residual offset of 10 mV= ~10% of an available sample eye).

Another approach has been to use a system level calibration technique. A training pattern is sent from the transmitter with the receiver samplers going through iterations until suitable calibration settings are obtained. Unfortunately, this requires a back-channel communication between the 2 dies or chips during a cold-boot with retraining leading to additional power and lower throughput. Another drawback is that it does not work when the voltage swing at the AFE output is high and is not operating in a linear region which is typical with low lossy channels. Accordingly, new approaches for calibrating sampler circuit offset would be desired.

In some embodiments, the AFE output may be tuned to a reference voltage that is used for the sampler thresholds in order to create a virtual short between the sampler inputs and thereby indirectly reducing the sampler input offset levels. In this way, samplers may be calibrated for offset at a block level without having to disconnect the sampler input from an AFE output. Moreover, special training from a transmitter is not required.

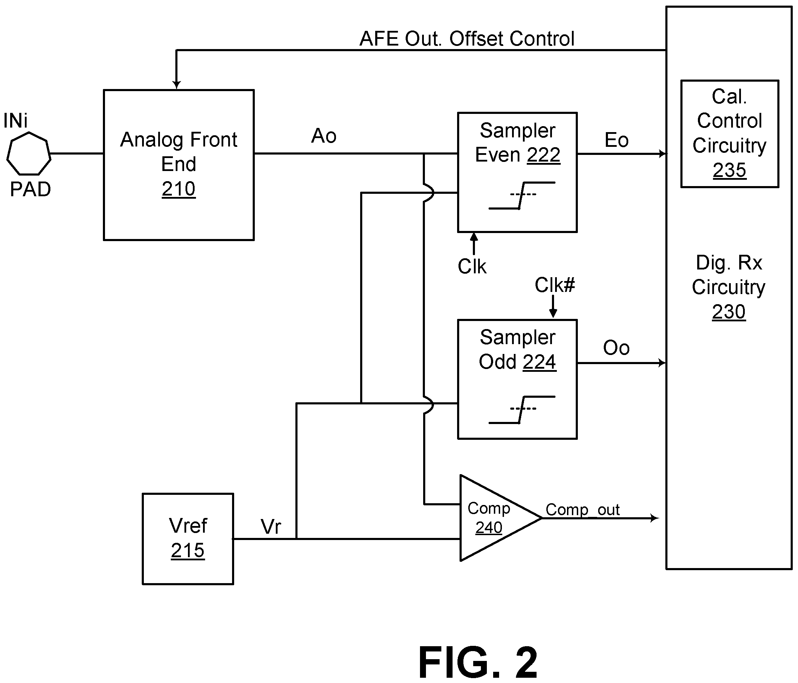

Fig. 2 is a circuit diagram showing a portion of a receiver with offset calibration in accordance with some embodiments. The circuit includes an analog front end (AFE) circuit 210, voltage reference (Vref) circuit 215, first (even) and second (odd) sampler circuits 222, 224, respectively, digital receiver circuitry 230, and comparator 240, all coupled together as shown. The receiver circuit has an input node (Ini) to receive and analog input data signal from a channel (not shown) that may correspond to a single lane in a multi-bit link such as a die-to-die or package to package link. For example, it could be configured in accordance with the Universal Chip Interconnect Express (UCIe) specification such as UCIe 1.1 released in August of 2023. The receiver circuit receives the analog data input signal and from that, it generates even and odd digital bit stream signals at output nodes (Eo, Oo, respectively). From there, the digital bit stream signals are further processed by digital circuitry 230.

The AFE circuit (or simply AFE) 210 is used for signal conditioning. It has an input node (INi) to receive the input data signal from the single-ended channel. In some embodiments, the AFE 210 includes amplification and possibly equalization circuitry to amplify, and also possibly equalize, the input signal and provide the amplified and equalized version at an output node (Ao). The AFE 210 also has a control input (AFE Output Offset Control) to control an offset level (e.g., DC offset component of Ao) produced by the AFE at its Ao output. As discussed below, this allows for the Ao output to be tuned to a calibration level for calibrating the sampler offsets.

The sampler circuits (222, 224) are used to sample the AFE output (Ao). In the depicted embodiment, they each have inputs for receiving the Ao outputs without having to pass through calibration switches, which might otherwise distort calibration settings for operational efficacy. The sampler circuits (or simply samplers) each include circuitry to compare the AFE output (Ao) against a reference voltage (Vr) from the Vref reference voltage circuitry 215. In operation, Clock signals (Clk, Clk#) serve to cyclically control when the comparisons are made (e.g., within the data "eye" of analog data stream signal Ao) in order to generate the digital data streams (Eo, O.) from the even and odd sampler circuits (222, 224), respectively. The clock signals (Clk, Clk#) may be 180 degrees out of phase when the sampler circuits use equivalent configurations so that one may sample off a rising clock edge while the other samples off a falling clock edge.

The Vref circuit 240 generates a suitable reference voltage (Vr) such as a value that is halfway between the input range of the sampler circuits 222, 224 so as to more readily facilitate digital data streams (Eo, Oo) with 50% duty cycles.

During a calibration mode, the AFE and samplers are calibrated to reduce offset at the sampler inputs. The AFE 210 output is controlled through its Output Offset Control input to tune a DC offset portion of Ao to be at the Vr level. This is done using comparator 240 to determine when the Ao output is the same (or sufficiently near) the level of Vr. In effect, this creates a virtual short at the inputs of each of the samplers without having to physically short them together. Once the virtual short is created (Ao=Vr), the outputs of the samplers are decided by their own offsets. Accordingly, the Dig. Block circuit 230 can then adjust the drive strengths of the sampler inputs until their offsets are sufficiently reduced. (it should be appreciated that while two sampler circuits (odd, even) for double data rate operation are shown, other embodiments may use only one sampler for each analog data stream lane, or they may even employ more than two samplers, depending on design considerations.

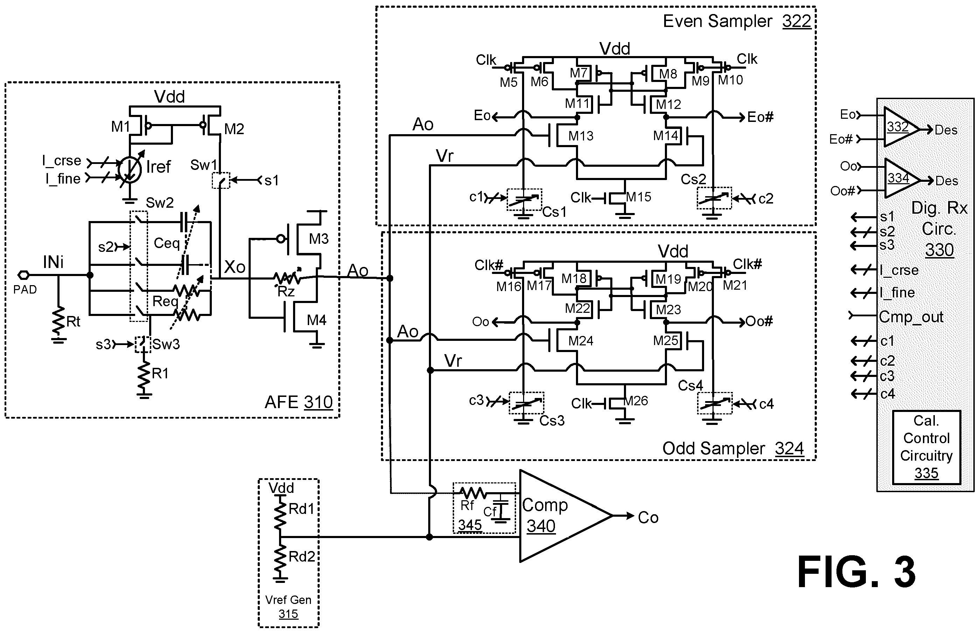

Fig. 3 is a schematic diagram showing a portion of a receiver circuit having offset calibration in accordance with some embodiments. The circuit includes AFE 310, Vref generation circuit 315, Even sampler circuit 322, odd sampler circuit 324, digital Rx circuitry 330, comparator 340, and low pass filter 345, all coupled together as shown.

The AFE circuit 310 implements a variable gain amplifier (VGA) with continuous time linear equalization (CTLE) in accordance with some embodiments. The AFE has an input node (INi) to receive a single-ended analog bit stream over a channel (not shown). There is also a channel termination resistor (Rt) coupled between the input node and a ground reference. This receiver circuit may be part of a channel in a multi-bit link such as a die-to-die or package to package link, which may be configured in accordance with a universal chip interconnect (UCI) implementation as mentioned above.

The depicted AFE 310 includes a mirrored driver circuit formed from variable current source (Iref) and mirrored transistors (M1, M2) as shown. The variable current source may be implemented, for example, with a current mode digital to analog converter (IDAC) and has course (I_crse) and fine (I fine) tune current control setting inputs that are controlled by corresponding control lines from digital Rx circuitry 330. In some embodiments, the course and fine control inputs are digitally controlled current driver legs for controlling the strength of the current through transistor M1 and thus through M2 as well. For example, the course control could be controlled with a six bit value (e.g., binary or thermometer coded), and the fine tune control could be controlled with a 5 bit value (e.g., binary or thermometer coded). With the use of separate course and fine control interfaces, increased driver strength resolution (transistors M1, M2) may be attained without having to use an excess number of bit lines. There is also a switch Sw1 (controlled through control input s1) coupled between M2 and node (Xo) to control whether or not the drive circuitry is active or disabled from the AFE.

In the depicted embodiment, the AFE 310 has an equalization circuit formed from a configurable combination of controllable equalization resistors and capacitors (Req, Ceq) coupled in parallel with each other as shown. They include a plurality of switches (Sw2), controllable through control signal s2, to couple, or decuple them, from between the input node (INi) and an equalization output node (Xo). The channel (e.g., wire or trace connecting the receiver to a corresponding transmitter) to which the receiver is mounted may be tested along with other channels in a link to identify suitable combination of the resistors (req) and capacitors (Ceq) that may be enabled, or programmed, to achieve a desired frequency response for the equalized signal at node Xo.

The AFE 310 also has a variable gain amplification circuit portion formed from transistors M3, M4 and a variable resistance Rz, coupled as shown to provide adjustable trans impedance amplification between node (Xo) and AFE output node (Ao). The amount of amplification depends on the value of Rz, which may be adjusted, or tuned, for example, during a manufacturing phase or even later, either through external or internal programming processes.

For calibration purposes, the AFE circuit also has switch Sw3 (controlled through input control s3) and resistor R1, coupled as shown. When switches Sw2 are closed and switch Sw3 is open, the AFE is in an active operational state to equalize and amplify a signal from input (INi) to output (Ao). On the other hand, when switches S2 are open and switch Sw3 is closed, the equalization circuit portion is decoupled from the AFE, which allows for the AFE output (Ao) to be statically calibrated to the Vref voltage (Vr) as will be discussed below, through adjustment of the adjustable current source (Iref).

The Vref Generation circuit 315 includes voltage divider resistors (Rd) coupled between a ground and a voltage supply (Vdd) to generate a reference voltage (Vr). In the depicted embodiment, the resistors (Rd) are equal to one another to generate a Vr value that is equal to Vdd/2, which conveniently facilitates a 50% duty cycle for the digital data streams to be generated by the sampler circuits.

For brevity sake, since the odd and even sampler circuits are highly similar, a detailed description will be limited to the even circuit 322, although the same principles apply as well to the odd sampler circuit 324, except that it operates off of a different clock edge from the even sampler 322.

The even sampler circuit 322 includes clock switch transistors (M5, M6, M9, M10, M15), cross-coupled flip/hold transistors (M7, M8, M11, M12), differential input transistors (M13, M14), and variable capacitors (Cs1, Cs2), coupled together as shown. The differential input transistors (M13, M14) have inputs Ao, Vr, respectively, for comparing the input voltages against one another. In turn, their drains serve as differential output nodes (Eo/E.#) That can indicate whether Ao is larger than Vr (Eo/Eo# = Low) or whether Ao is smaller than Vr (Eo/Eo# = High).

The adjustable capacitors (Cs1, Cs2) have inputs (c1, c2, respectively) to control their capacitances in order to tune the effective and relative strengths of their associated drive legs (paths through M13, M14, respectively) of the sampler. Among other things, they can be used to calibrate the effective offset of the sampler inputs between the inputs (Ao, Vr). Note that these input, control, and output signals are coupled with corresponding input/output nodes in the digital Rx circuitry 330, which includes, among other things, differential to single ended converter circuits 332, 334 to convert the differential sampler outputs (Eo/Eo# and Oo/Oo#, respectively) to downstream digital circuits such as deserialization and buffer circuits.

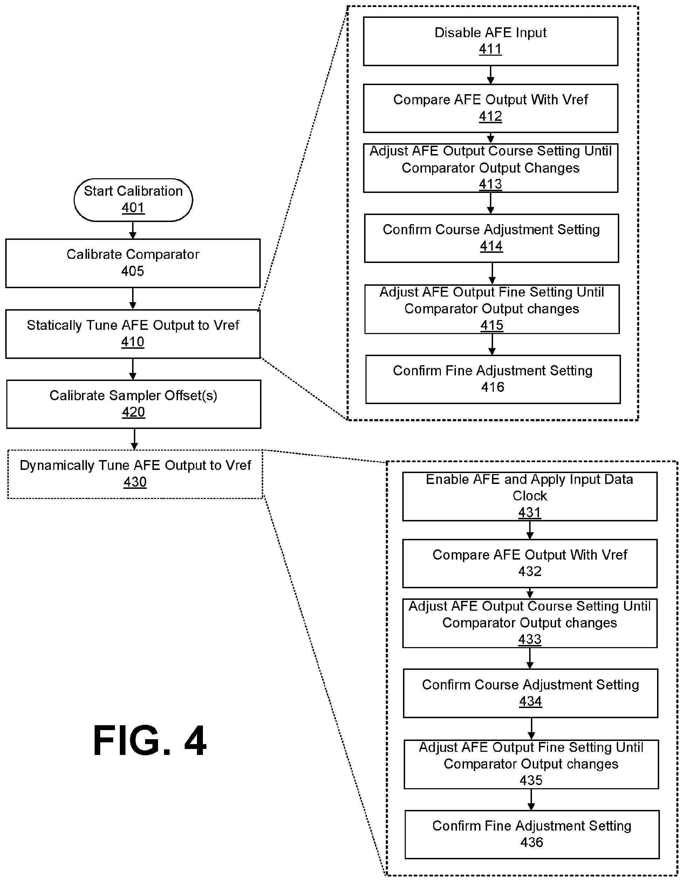

The digital Rx circuitry 330 also includes calibration control circuitry 335 to control calibration of sampler circuits 322 and 324. In some embodiments, the calibration control circuitry 335 may be formed from one or more microcontrollers, state machines and/or other logic circuits for controlling and processing various aspects of the depicted receiver circuitry to calibrate the sampler circuits. For example, it may interface, or even implement tuning of the AFE, along with calibration of the sampler offset levels, as well as the comparator. It may have dedicated circuits for performing these functions or it may share circuitry with other receivers or link management circuits within a package for part or all of the same. In some embodiments, it may perform calibration routines such as those discussed below with regard to Fig. 4.

In some embodiments, comparator 340 may be implemented with a low bandwidth comparator circuit (e.g., ~100 MHz.) but with low offset such as with a switched cap comparator. Alternatively, or in addition, calibration could also be applied to the comparator to reduce its offset. For example, a comparator with compensated residual offset of less than 1.5 mV may be used.

The low pass filter 345 is formed from resistor (Rf) and capacitor (Cf) coupled as shown. It should have cutoff frequency characteristics suitable to enable an AFE output (Ao) to be compared against Vr for dynamic calibration when a signal is applied at the input pad (Ini) in concert with the utilized clock frequency for the samplers. For example, with an 8 GHz. input test pattern (e.g., clock or pulse train) and 8 GHz. sampler circuit clocks, a 400 MHz. cutoff could be used. In some embodiments, the resistor should be high enough, with the capacitor placed at the comparator side of the resistor to prevent signal (Ao) from shorting through the capacitor to ground. For example, Rf could be 30 K'Ω with Cf being 1 pF.

Fig. 4 is a flow diagram showing a routine to calibrate a sampler circuit's offset in accordance with some embodiments. At 401, the routine begins. Note that for purposes of this routine, it is assumed that the equalization circuitry (Req, Ceq) and amplifier (Rz) have been tuned.

At 405, if necessary, the comparator 340 is calibrated to sufficiently reduce its input offset. At 410, the AFE output is then statically tuned to set Ao equal to the reference voltage (Vr). At 420, the samplers are then calibrated so their offset(s) are sufficiently reduced with the calibrated Ao and Vr at their inputs. At 430, the AFE output is once again calibrated but this time, it is dynamically tuned with an alternating current (AC) signal at its input being equalized and amplified through to the output node (Ao).

In some embodiments, the static tuning of the AFE may be performed as shown in Fig. 4 with some or all of actions 411-416. At 411, the AFE input is disabled, or decoupled, from an amplifying portion of the AFE responsible for a DC offset voltage at Ao. Decoupling the equalization circuitry from the input pad (INi) avoids the large swings at the amplifier output (Ao) that may otherwise occur. In the depicted embodiment, switches Sw2 are opened to decouple the equalization circuit from the AFE input, and switch Sw3 is closed so that there is a path from the TIA (trans impedance amplifier) input (Xo) to ground. In some embodiments, the value of resistor (R1) is selected so that the look-back impedance from the AFE output (Ao) sufficiently resembles that seen when the AFE is in operation.

At 412, the AFE output (Ao) is compared against Vr using comparator 340. Depending on if it is larger or smaller than Vr, the course adjustment setting for Iref is decremented, or incremented, so that Ao approaches Vr. At 413, this is done until the comparator output (Co) flips (i.e., changes state). Next, at 414, the routine confirms the course setting corresponds with the changing comparator state, e.g., by moving the course setting one or more steps back and forth and confirming that it is causing the comparator to change in response thereto. This may be done to confirm that the course setting adjustment, and not some noise or other spurious event, caused the comparator flip to occur. If so confirmed, the course setting at the flip point is saved and the routine proceeds.

At 415, with the course setting at its identified flip value, the routine adjusts the fine Iref setting, e.g., in the same manner as with the course setting, to move Ao toward the flip level. It does this until the comparator flips and at 416, it confirms this setting is valid as was done for the course setting.

After static AFE offset tuning to Vr, both of the inputs for each sampler are at (or sufficiently near) Vr (e.g., Vdd/2), which creates a virtual short between the inputs of each sampler. At this stage, the outputs of the samplers will be decided by their own offsets. With the AFE Iref settings at their tuned levels for Ao to equal Vr, at 420, the sampler input offsets are calibrated. They are provided with suitable input clocks (e.g., 8 GHz clocks), and their variable capacitors (Cs1, Cs2 for even sampler and Cs3, Cs4 for odd sampler) are adjusted until their outputs flip. This may be done similarly as was done for the AFE Iref adjustments. Either or both legs of the sampler inputs may be adjusted to achieve the smallest reasonable offset between each sampler's input nodes.

Next, at 430, with the AFE at its current statically calibrated settings and the samplers a their input offset calibrated settings, the AFE is then dynamically tuned with its input section enabled while receiving an input signal that is reflective of an operational use case. An exemplary flow is illustrated at 431-436. At 431, the AFE is enabled with Sw2 closed and Sw3 open. An input test pattern (e.g., a conventional clock at 8 GHz.) is applied at the input (INi). At 432-436, the Iref settings are further tuned, as above, but now with the test input being applied. With the use of the low pass filter (345), even with a generated AC signal at Ao, the comparator 340 can compare the Ao signal's lower frequency (DC offset) component against the reference voltage (Vr). Note that a data, or test, pattern at the AFE input is not used until the DC offset has initially been calibrated (static calibration), so non-linearities due to high swings at Ao may be avoided.

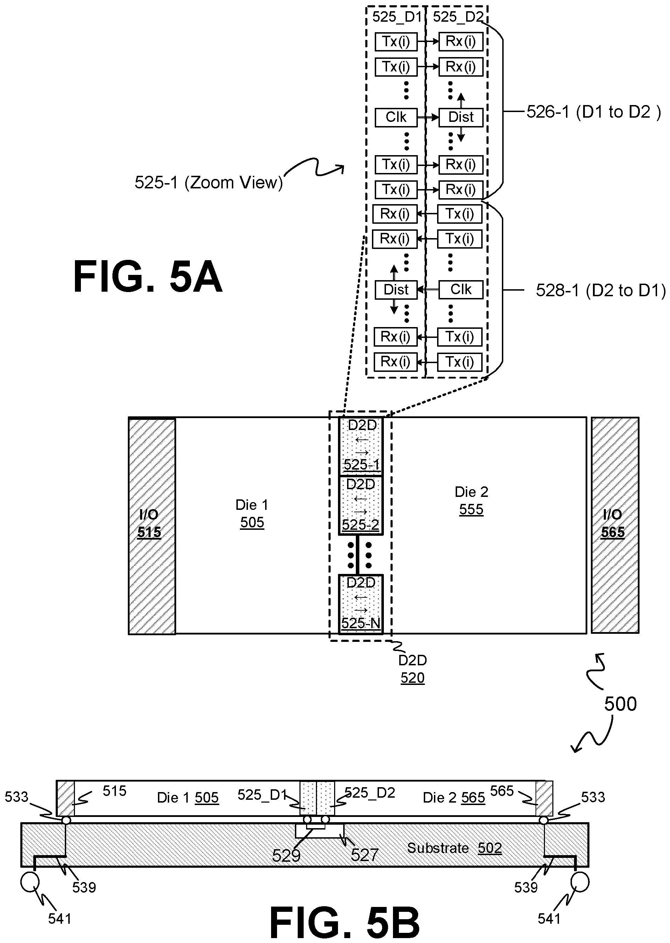

Figs. 5A and 5B are top and side view diagrams showing an exemplary multi-die package having die-to-die interconnect links in accordance with some embodiments. Package 500 has a first die 505 coupled to a second die 555 through a block 520 of die-to-die (D2D) links 525 (525_1-525-N). For example, the D2D links may be implemented with D2D links such as with a link interface configured in accordance with a Universal Chiplet Interconnect Express (UCIe) protocol. Also shown are I/O sections 515, 565 for providing off-chip transceiver interfaces, e.g., for DDR or PCIe links outside of the IC package.

A zoomed view of a D2D link (525-1) is depicted in Fig. 5A. The link generally includes a multiplicity (e.g., 16, 32, etc.) of bi-directional lanes formed from a multiplicity of single-ended Tx (Die 1) to Rx (Die 2) circuits 526-1, along with an associated Die 1 to Die 2 clock generation circuit, to transmit data from Die 1 to Die 2. Likewise, it has multiplicity of single-ended Tx (Die 2) to Rx (Die 1) circuits 528-1, along with an associated Die 2 to Die 1 clock generation circuit, to transmit data from Die 2 to Die 1. Each of the Rx circuits may be implemented with one or more sampler circuits having offset calibration as described herein.

The D2D Tx/Rx circuits may be coupled to their counterpart circuits on the other die through D2D wires, traces, or any suitable structure. For example, as shown in Fig. 5B, they may be coupled together through wires 529 that are embedded within a bridge 527, which in this example, are disposed in a multi-die substrate 502. The D2D block sections are aligned next to each other, which allows for them to be coupled together using the bridges. Likewise, the I/O blocks 515, 565 are disposed on the outside edges (outer edge of Die 1 and outer edge of Die 2), making them accessible for off-chip communications. In this example, the I/O and D2D sections may be coupled to the bridges and/or to contacts on the substrate through micro-bumps 533. In turn, any or some of these connections may be brought off-package through substrate wires 539 and package bumps 541.

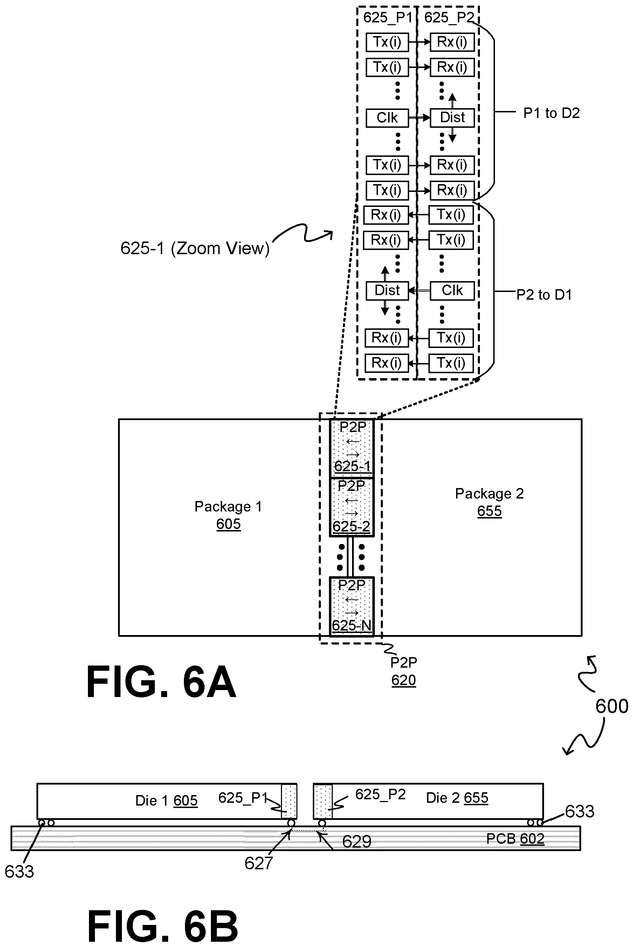

Figs. 6A and 6B are top and side view diagrams showing an exemplary multi-package apparatus having package-to-package interconnect links in accordance with some embodiments. Apparatus 600 has a first package 605, with one or more dies, coupled to a second package 655, with one or more dies, through a block (or section) 620 of package-to-package (P2P) links 625 (625-1 to 625-N). For example, the P2P links may be implemented with P2P links such as with a link interface configured in accordance with a Universal Chiplet Interconnect Express (UCIe) protocol.

A zoomed view of a P2P link (625-1) is depicted in Fig. 6A. The link generally includes a multiplicity (e.g., 16, 32, etc.) of bi-directional lanes formed from a multiplicity of single-ended Tx (Package 1) to Rx (Package 2) circuits 626-1, along with an associated Package 1 to Package 2 clock generation circuit, to transmit data from Package 1 to Package 2. Likewise, it has a corresponding multiplicity of single-ended Tx (Package 2) to Rx (Package 1) circuits 628-1, along with an associated Package 2 to Package 1 clock generation circuit, to transmit data from Package 2 to Package 1. Each of the Rx circuits may be implemented with one or more sampler circuits having offset calibration as described herein. This may be particularly beneficial with package to package links that can have channel lengths of up to 120 or more microns. With these, and other implementations, some embodiments can reduce insertion loss penalties and kick-back noise due to impedance mismatch seen from sampler inputs.

The P2P Tx/Rx circuits may be coupled to their counterpart circuits on the other die through P2P wires, traces, or any suitable structure. For example, as shown in Fig. 6B, they may be coupled together through vias 627 and board wires (or metal layer traces) 629 that are embedded within a printed circuit board (PCB) 602. The P2P block sections are aligned next to each other, which allows for them to be coupled together using the links. In this example, the P2P sections may be coupled to contacts on the PCB through bumps or ball contacts 633.

It should be appreciated that any suitable structures may be used for connecting dies or die packages to each other through Tx/Rx<>Rx/Tx channels as described herein. For example, wafer-level fan-out redistribution, using reconstituted wafer substrates of molding compounds as the surface for interconnections between dies may be used in 2D or 2.5D implementations. Similarly, with some methods, a separate, usually silicon-based, interconnect layer for redistribution could be used. For example, either an interposer (passive and/or active, typically formed from silicon) or die-to-die bridges (e.g., such as silicon bridges as shown in Fig. 5B) embedded in an organic surface (e.g., substrate surface or interposer) could be employed. Along these lines, any suitable structures in cooperation with printed circuit board techniques could be used to link die packages with one another. It may be desirable to link together die packages such as when they are made by different original equipment manufactures. For example, a compute module could be formed from connecting together on a common circuit board graphics processors from one supplier and central processors or system on chips (SoCs) from another supplier. They may already be packaged, so links such as UCIe links employing offset calibration may be utilized for higher communication speeds between the packages.

As used herein a printed circuit board (PCB), also known as a printed wiring board (PWB), may be formed from any suitable medium used to connect components in an electronic circuit. They generally include conductive and insulating layers with patterns of traces, along possibly with electronic components such as passive elements incorporated there within, and they may be rigid, or they may be formed partially or wholly from flexible structures.

As used herein, an integrated circuit package, or simply package, is one or more coupled-together integrated circuit dies contained within a protective case that encapsulates the integrated circuit die(s).

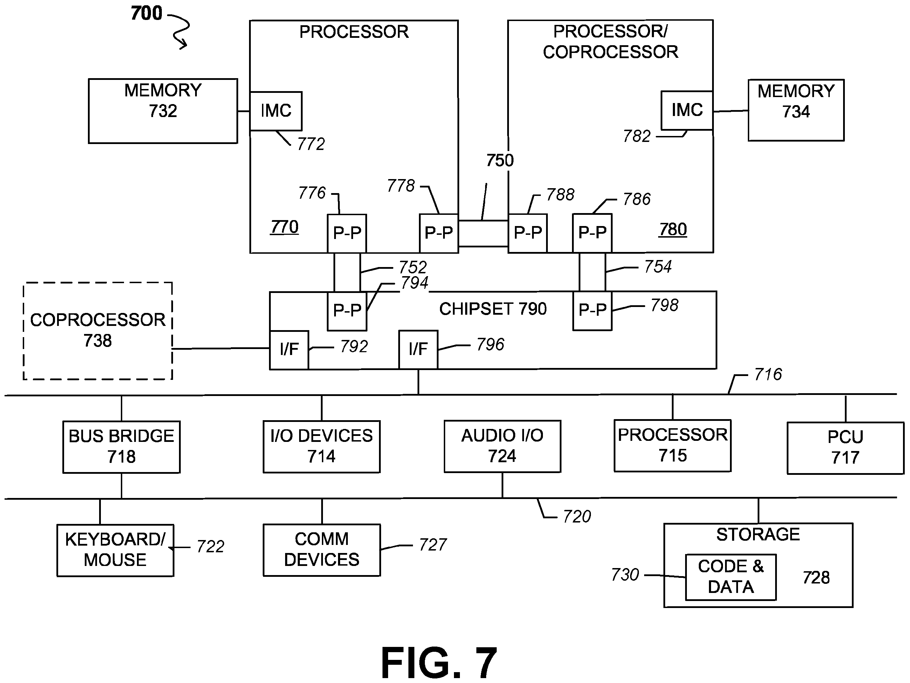

Fig. 7 illustrates an example computing system in accordance with some embodiments. Multiprocessor system 700 is an interfaced system and includes a plurality of processors including a first processor 770 and a second processor 780 coupled via an interface 750 such as a point-to-point (P-P) interconnect employing single-ended receiver circuits as described above, a fabric, and/or bus. In some examples, the first processor 770 and the second processor 780 are homogeneous. In some examples, first processor 770 and the second processor 780 are heterogenous. Though the example system 700 is shown to have two processors, the system may have three or more processors, or may be a single processor system. In some examples, the computing system is implemented, wholly or partially, with a system on a chip (SoC) or a multichip (or multi-chiplet) module, in the same or in different package combinations that may be linked together using links with receivers having sampler offset calibration as described herein.

Processors 770 and 780 are shown including integrated memory controller (IMC) circuitry 772 and 782, respectively. Processor 770 also includes interface circuits 776 and 778, along with core sets. Similarly, second processor 780 includes interface circuits 786 and 788, along with a core set as well. A core set generally refers to one or more compute cores that may or may not be grouped into different clusters, hierarchal groups, or groups of common core types. Cores may be configured differently for performing different functions and/or instructions at different performance and/or power levels. The processors may also include other blocks such as memory and other processing unit engines.

Processors 770, 780 may exchange information via the interface 750 using interface circuits 778, 788. IMCs 772 and 782 couple the processors 770, 780 to respective memories, namely a memory 732 and a memory 734, which may be portions of main memory locally attached to the respective processors.

Processors 770, 780 may each exchange information with a network interface (NW I/F) 790 via individual interfaces 752, 754 using interface circuits 776, 794, 786, 798. The network interface 790 (e.g., one or more of an interconnect, bus, and/or fabric, and in some examples is a chipset) may optionally exchange information with a coprocessor 738 via an interface circuit 792. In some examples, the coprocessor 738 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 770, 780 or outside of both processors, yet connected with the processors via an interface such as P-P interconnect, such that either or both processors' local cache information may be stored in the shared cache if a processor is placed into a low power mode.

Network interface 790 may be coupled to a first interface 716 via interface circuit 796. In some examples, first interface 716 may be an interface such as a Peripheral Component Interconnect (PCI) interconnect, a PCI Express interconnect, or another I/O interconnect. In some examples, first interface 716 is coupled to a power control unit (PCU) 717, which may include circuitry, software, and/or firmware to perform power management operations with regard to the processors 770, 780 and/or co-processor 738. PCU 717 provides control information to one or more voltage regulators (not shown) to cause the voltage regulator(s) to generate the appropriate regulated voltage(s). PCU 717 also provides control information to control the operating voltage generated. In various examples, PCU 717 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 717 is illustrated as being present as logic separate from the processor 770 and/or processor 780. In other cases, PCU 717 may execute on a given one or more of cores (not shown) of processor 770 or 780. In some cases, PCU 717 may be implemented as a microcontroller (dedicated or general-purpose) or other control logic configured to execute its own dedicated power management code, sometimes referred to as P-code. In yet other examples, power management operations to be performed by PCU 717 may be implemented externally to a processor, such as by way of a separate power management integrated circuit (PMIC) or another component external to the processor. In yet other examples, power management operations to be performed by PCU 717 may be implemented within BIOS or other system software. Along these lines, power management may be performed in concert with other power control units implemented autonomously or semi-autonomously, e.g., as controllers or executing software in cores, clusters, IP blocks and/or in other parts of the overall system.

Various I/O devices 714 may be coupled to first interface 716, along with a bus bridge 718 which couples first interface 716 to a second interface 720. In some examples, one or more additional processor(s) 715, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 716. In some examples, second interface 720 may be a low pin count (LPC) interface. Various devices may be coupled to second interface 720 including, for example, a keyboard and/or mouse 722, communication devices 727 and storage circuitry 728. Storage circuitry 728 may be one or more non-transitory machine-readable storage media as described below, such as a disk drive or other mass storage device which may include instructions/code and data 730 and may implement the storage in some examples. Further, an audio I/O 724 may be coupled to second interface 720. Note that other architectures than the point-to-point architecture described above are possible. For example, instead of the point-to-point architecture, a system such as multiprocessor system 700 may implement a multi-drop interface or other such architecture.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality. Example core architectures are described next, followed by descriptions of example processors and computer architectures.

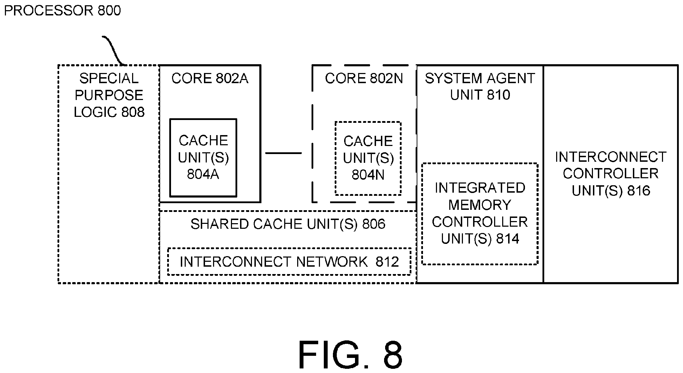

Fig. 8 illustrates a block diagram of an example processor and/or SoC 800 that may have one or more cores and an integrated memory controller in accordance with some embodiments. The solid lined boxes illustrate a processor 800 with a single core 802(A), system agent unit circuitry 810, and a set of one or more interface controller unit(s) circuitry 816, while the optional addition of the dashed lined boxes illustrates an alternative processor 800 with multiple cores 802(A)-(N), a set of one or more integrated memory controller unit(s) circuitry 814 in the system agent unit circuitry 810, and special purpose logic 808, as well as a set of one or more interface controller units circuitry 816. Note that the processor 800 may be one of the processors 770 or 780, or co-processor 738 or 715 of FIG. 7.

Thus, different implementations of the processor 800 may include: 1) a CPU with the special purpose logic 808 being integrated graphics and/or scientific (throughput) logic (which may include one or more cores, not shown), and the cores 802(A)-(N) being one or more general purpose cores (e.g., general purpose in-order cores, general purpose out-of-order cores, or a combination of the two); 2) a coprocessor with the cores 802(A)-(N) being a large number of special purpose cores intended primarily for graphics and/or scientific (throughput); and 3) a coprocessor with the cores 802(A)-(N) being a large number of general purpose in-order cores. Thus, the processor 800 may be a general-purpose processor, coprocessor or special-purpose processor, such as, for example, a network or communication processor, compression engine, graphics processor, GPGPU (general purpose graphics processing unit), a high throughput many integrated core (MIC) coprocessor (including 30 or more cores), embedded processor, or the like. The processor may be implemented on one or more chips. The processor 800 may be a part of and/or may be implemented on one or more substrates using any of a number of process technologies, such as, for example, complementary metal oxide semiconductor (CMOS), bipolar CMOS (BiCMOS), P-type metal oxide semiconductor (PMOS), or N-type metal oxide semiconductor (NMOS).

A memory hierarchy includes one or more levels of cache unit(s) circuitry 804(A)-(N) within the cores 802(A)-(N), a set of one or more shared cache unit(s) circuitry 806, and external memory (not shown) coupled to the set of integrated memory controller unit(s) circuitry 814. The set of one or more shared cache unit(s) circuitry 806 may include one or more mid-level caches, such as level 2 (L2), level 3 (L3), level 4 (L4), or other levels of cache, such as a last level cache (LLC), and/or combinations thereof. While in some examples interface network circuitry 812 (e.g., a ring interconnect) interfaces the special purpose logic 808 (e.g., integrated graphics logic), the set of shared cache unit(s) circuitry 806, and the system agent unit circuitry 810, alternative examples use any number of well-known techniques for interfacing such units. In some examples, coherency is maintained between one or more of the shared cache unit(s) circuitry 806 and cores 802(A)-(N). In some examples, interface controller units circuitry 816 couple the cores 802 to one or more other devices 818 such as one or more I/O devices, storage, one or more communication devices (e.g., wireless networking, wired networking, etc.), etc.

In some examples, one or more of the cores 802(A)-(N) are capable of multi-threading. The system agent unit circuitry 810 includes those components coordinating and operating cores 802(A)-(N). The system agent unit circuitry 810 may include, for example, power control unit (PCU) circuitry and/or display unit circuitry (not shown). The PCU may be or may include logic and components needed for regulating the power state of the cores 802(A)-(N) and/or the special purpose logic 808 (e.g., integrated graphics logic). The display unit circuitry is for driving one or more externally connected displays.

The cores 802(A)-(N) may be homogenous in terms of instruction set architecture (ISA). Alternatively, the cores 802(A)-(N) may be heterogeneous in terms of ISA; that is, a subset of the cores 802(A)-(N) may be capable of executing an ISA, while other cores may be capable of executing only a subset of that ISA or another ISA.

Illustrative examples of the technologies disclosed herein are provided below. An embodiment of the technologies may include any one or more, and any compatible combination of, the examples described below.

Example 1 is an apparatus that includes analog front end, sampler, and comparator circuits. The analog front end (AFE) circuit has an AFE input, an AFE output, and an AFE output- offset control input. The sampler circuit has sampler signal and sampler reference inputs, the sampler signal input being coupled to the AFE output. The comparator has first and second comparator inputs. The first comparator input is coupled to a voltage reference output and the second comparator input is coupled to the AFE output.

Example 2 includes the subject matter of example 1, and comprises a control circuit coupled to the AFE output-offset control input to control the AFE output offset to be at a voltage level that corresponds to a reference voltage at the voltage reference output.

Example 3 includes the subject matter of any of examples 1-2, and wherein the AFE output-offset control input is a digital interface to a digitally controllable current drive circuit.

Example 4 includes the subject matter of any of examples 1-3, and wherein the AFE circuit includes an amplifier circuit to generate an amplified voltage at the AFE output, wherein the AFE circuit has one or more first switches to decouple the AFE input from the amplifier during a calibration mode when an offset component of the amplified voltage is to be tuned.

Example 5 includes the subject matter of any of examples 1-4, and wherein the amplifier is a trans impedance amplifier.

Example 6 includes the subject matter of any of examples 1-5, and wherein the AFE includes an equalization circuit coupled between the AFE input and an input of the amplifier.

Example 7 includes the subject matter of any of examples 1-6, and wherein the AFE has one or more second switches to couple the amplifier input to a ground reference through a resistor.

Example 8 includes the subject matter of any of examples 1-7, and comprises a low-pass filter coupled between the AFE output and the second comparator input.

Example 9 includes the subject matter of any of examples 1-8, and wherein the low-pass filter includes a filter resistor coupled between the AFE output and the second comparator input and a capacitor coupled between the second comparator input and a ground reference.

Example 10 includes the subject matter of any of examples 1-9, and wherein the filter resistor has a resistance of at least 20K Ohms.

Example 11 includes the subject matter of any of examples 1-10, and wherein the voltage reference circuit includes resistors to generate a reference voltage that is one-half of a voltage supplied to the voltage reference circuit from a voltage supply.

Example 12 includes the subject matter of any of examples 1-11, and wherein the voltage supply is coupled to the sampler circuit.

Example 13 includes the subject matter of any of examples 1-12, and wherein the sampler reference input is coupled to the voltage reference output, and the sampler circuit has a sampler offset control input to control a voltage difference between the sampler signal and sampler reference inputs.

Example 14 includes the subject matter of any of examples 1-13, and wherein the sampler circuit is a first sampler circuit, the apparatus further comprising a second sampler circuit coupled, in parallel with the first sampler circuit, to the AFE and voltage reference circuit, the first and second sampler circuits to be triggered off of different phases of a common clock.

Example 15 is an apparatus that includes an AFE circuit, a sampler circuit, and a calibration control circuit. The analog front end (AFE) circuit has an AFE input and an AFE output. The sampler circuit has sampler signal and sampler reference inputs with the sampler signal input being coupled to the AFE output, and the sampler reference input being coupled to a voltage reference node to receive a reference voltage. The calibration control circuit performs a calibration method that includes: tuning the AFE output to the reference voltage, monitoring an output of the sampler, and tuning the sampler to reduce an offset between the sampler signal and reference inputs based on the sampler output.

Example 16 includes the subject matter of example 15, and wherein the calibration method includes decoupling the AFE input from the AFE output before tuning the AFE Output.

Example 17 includes the subject matter of any of examples 15-16, and wherein the calibration method includes providing an alternating current (AC) signal at the AFE input when the AFE input is not decoupled from the AFE output and tuning the AFE output to the reference voltage when the AC signal is at the AFE input.

Example 18 includes the subject matter of any of examples 15-17, and comprising a comparator having first and second comparator inputs, the first comparator input coupled to the voltage reference node, and the second comparator input coupled to the AFE output,

Example 19 includes the subject matter of any of examples 15-18, and comprises a low-pass filter coupled between the AFE output and the second comparator input.

Example 20 includes the subject matter of any of examples 15-19, and wherein the low-pass filter includes a filter resistor coupled between the AFE output and the second comparator input and a capacitor coupled between the second comparator input and a ground reference.

Example 21 includes the subject matter of any of examples 15-20, and wherein the calibration control circuit is coupled to a digital interface of the AFE circuit to adjust a digitally controllable current drive circuit to tune the AFE output.

Example 22 includes the subject matter of any of examples 15-21, and wherein the AFE circuit includes an amplifier circuit to generate an amplified voltage at the AFE output, wherein the AFE circuit has one or more switches to decouple the AFE input from the amplifier when the AFE output is tuned before the sampler is tuned.

Example 23 includes the subject matter of any of examples 15-22, and wherein the AFE includes an equalization circuit coupled between the AFE input and an input of the amplifier.

Example 24 includes the subject matter of any of examples 15-23, and wherein the AFE has a first calibration mode switch to couple the amplifier input to a ground reference through a resistor.

Example 25 is an integrated circuit package that has a block of single-ended receivers having circuitry in accordance with the subject matter of any of examples 15-24.

Example 26 includes the subject matter of any of examples 15-25, and wherein the calibration control circuit is at least partially implemented with a finite state machine to perform the method.

Example 27 is an apparatus that includes first and second IC packages. The first integrated circuit (IC) package has a plurality of single-ended data transmitters and at least one clock transmitter. The second IC package has a plurality of single-ended data receivers coupled to the data transmitters over a plurality of channels and at least one clock receiver coupled to the clock transmitter over at least one channel, and each receiver includes and AFE circuit, a sampler circuit, and a comparator circuit. The analog front end (AFE) circuit has an AFE input, an AFE output, and an AFE output- offset control input. The sampler circuit has sampler signal and sampler reference inputs. The sampler signal input is coupled to the AFE output. The comparator has first and second comparator inputs. The first comparator input is coupled to a voltage reference output, and the second comparator input coupled to the AFE output.

Example 28 includes the subject matter of example 27, and comprising a control circuit coupled to the AFE output-offset control input to control the AFE output offset to be at a voltage level that corresponds to a reference voltage at the voltage reference output.

Example 29 includes the subject matter of any of examples 27-28, and wherein the AFE output-offset control input is a digital interface to a digitally controllable current drive circuit.

Example 30 includes the subject matter of any of examples 27-29, and wherein the AFE circuit includes an amplifier circuit to generate an amplified voltage at the AFE output, wherein the AFE circuit has one or more first switches to decouple the AFE input from the amplifier during a calibration mode when an offset component of the amplifier voltage is to be tuned.

Example 31 includes the subject matter of any of examples 27-30, and wherein the amplifier is a trans impedance amplifier.

Example 32 includes the subject matter of any of examples 27-31, and wherein the AFE includes an equalization circuit coupled between the AFE input and an input of the amplifier.

Example 33 includes the subject matter of any of examples 27-32, and wherein the AFE has one or more second switches to couple the amplifier input to a ground reference through a resistor.

Example 34 includes the subject matter of any of examples 27-33, and comprises a low-pass filter coupled between the AFE output and the second comparator input.

Example 35 includes the subject matter of any of examples 27-34, and wherein the low-pass filter includes a filter resistor coupled between the AFE output and the second comparator input and a capacitor coupled between the second comparator input and a ground reference.

Example 36 includes the subject matter of any of examples 27-35, and wherein the filter resistor has a resistance of at least 20K Ohms.

Example 37 includes the subject matter of any of examples 27-36, and wherein the voltage reference circuit includes resistors to generate a reference voltage that is one-half of a voltage supplied to the voltage reference circuit from a voltage supply.

Example 38 includes the subject matter of any of examples 27-37, and wherein the voltage supply is coupled to the sampler circuit.

Example 39 includes the subject matter of any of examples 27-38, and wherein the sampler reference input is coupled to the voltage reference output, and the sampler circuit has a sampler offset control input to control a voltage difference between the sampler signal and sampler reference inputs.

Example 40 includes the subject matter of any of examples 27-39, and wherein the sampler circuit is a first sampler circuit, the apparatus further comprising a second sampler circuit coupled, in parallel with the first sampler circuit, to the AFE and voltage reference circuit, the first and second sampler circuits to be triggered off of different phases of a common clock.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

The meaning of "in" includes "in" and "on" unless expressly distinguished for a specific description.

The terms "substantially," "close," "approximately," "near," and "about," unless otherwise indicated, generally refer to being within +/-10% of a target value.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

For purposes of the embodiments, unless expressly described differently, the transistors in various circuits and logic blocks described herein may be implemented with any suitable transistor type such as field effect transistors (FETs) or bipolar type transistors. FET transistor types may include but are not limited to metal oxide semiconductor (MOS) type FETs such as tri-gate, FinFET, and gate all around (GAA) FET transistors, as well as tunneling FET (TFET) transistors, ferroelectric FET (FeFET) transistors, or other transistor device types such as carbon nanotubes or spintronic devices.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are dependent upon the platform within which the present disclosure is to be implemented.

As defined herein, the term "if' means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, a system on a chip (SoC), an application processor, an integrated circuit incorporating a combination of one or more of the aforesaid items, etc.

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

While the invention has been described in terms of several embodiments, those skilled in the art will recognize that the invention is not limited to the embodiments described, can be practiced with modification and alteration within the spirit and scope of the appended claims. The description is thus to be regarded as illustrative instead of limiting.

## Claims

1. An apparatus with at least one receiver circuit, comprising:
an analog front end, AFE, circuit having an AFE input, an AFE output, and an AFE output-offset control input;
a sampler circuit having sampler signal and sampler reference inputs, the sampler signal input being coupled to the AFE output; and
a comparator having first and second comparator inputs, the first comparator input coupled to a reference node to receive a reference voltage and the second comparator input coupled to the AFE output.

2. The apparatus of claim 1, further comprising a calibration control circuit to perform a calibration method including:
tuning the AFE output to the reference voltage,
monitoring an output of the sampler circuit, and
tuning the sampler circuit to reduce an offset between the sampler signal and reference inputs based on the sampler output.

3. The apparatus of claim 2,
wherein the calibration method includes decoupling the AFE input from the AFE output before tuning the AFE Output.

4. The apparatus of any one of claims 2 to 3,
wherein the calibration method includes providing an alternating current (AC) signal at the AFE input when the AFE input is not decoupled from the AFE output and tuning the AFE output to the reference voltage when the AC signal is at the AFE input.

5. The apparatus of any one of claims 1 to 4,
wherein the AFE circuit includes an amplifier circuit to generate an amplified voltage at the AFE output, wherein the AFE circuit has one or more first switches to decouple the AFE input from the amplifier during a calibration mode when an offset component of the amplified voltage is to be tuned.

6. The apparatus of claim 5,
wherein the amplifier is a trans impedance amplifier.

7. The apparatus of claim 5 or claim 6,
wherein the AFE includes an equalization circuit coupled between the AFE input and an input of the amplifier.

8. The apparatus of any one of claims 5 to 7,
wherein the AFE has one or more second switches to couple the amplifier input to a ground reference through a resistor.

9. The apparatus of any one of claims 1 to 8, further comprising:
a low-pass filter coupled between the AFE output and the second comparator input.

10. The apparatus of claim 9,
wherein the low-pass filter includes a filter resistor coupled between the AFE output and the second comparator input and a capacitor coupled between the second comparator input and a ground reference.

11. The apparatus of claim 10,
wherein the reference node is coupled to the sampler circuit.

12. The apparatus of any one of claims 1 to 11,
wherein the sampler reference input is coupled to the voltage reference output, and the sampler circuit has a sampler offset control input to control a voltage difference between the sampler signal and sampler reference inputs.

13. The apparatus of any one of claims 1 to 12,
wherein the sampler circuit is a first sampler circuit, the apparatus further comprising a second sampler circuit coupled, in parallel with the first sampler circuit, to the AFE and voltage reference circuit, the first and second sampler circuits to be triggered off of different phases of a common clock.

14. The apparatus of any one of claims 1 to 13,
wherein the AFE output-offset control input is a digital interface to a digitally controllable current drive circuit.

15. An integrated circuit package with first and second dies coupled together through an interconnect link comprising the at least one receiver circuit in accordance with any one of claims 1 to 14.
